Europäisches Patentamt

European Patent Office

Office européen des brevets

(11) Publication number: **0 243 235**
**A2**

(12) # EUROPEAN PATENT APPLICATION

(21) Application number: 87400825.3

(22) Date of filing: 10.04.87

(51) Int. Cl.³: **H 03 K 5/01**

(30) Priority: 18.04.86 JP 89599/86

(43) Date of publication of application:
28.10.87 Bulletin 87/44

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Abe, Masato
3136-3, Kamitsuruma
Sagamihara-shi Kanagawa 228(JP)

(72) Inventor: Asami, Fumitaka
1-23-202, 27, Fujimidai 1-chome
Kunitachi-shi Tokyo 186(JP)

(74) Representative: Joly, Jean-Jacques et al,
CABINET BEAU DE LOMENIE 55, rue d'Amsterdam
F-75008 Paris(FR)

(54) Noise pulse suppressing circuit in a digital system.

(57) A latch circuit (16) receives and latches an input signal (b) in response to a triggering signal (k) and provides an output signal (c). A counter circuit (13) formed a plurality of D-type flip-flops (12, 14) receives a clock signal (a₀) and produces the triggering signal (k) when a predetermined number of trailing or leading edges of clock pulses have been counted. A logic circuit (11) is connected to the latch circuit (16) for generating a reset signal (h) which is applied to the counter circuit to reset same when the latch circuit output and the input signal have the same logic state and for making the counter circuit active when the latch circuit output and the input signal have complementary logic states. No level change in the output signal will occur if the duration of a level change in the input signal is not sufficient to allow the counter circuit to count the predetermined number of edges of clock pulses; thus enabling the suppression of noise pulses of either positive or negative polarity in the input signal and the production of an output signal having edges synchronized on leading or trailing edges of the clock signal.

FIG. 2

EP 0 243 235 A2

The present invention relates to a noise pulse suppressing circuit for a digital system.

When an input signal to a digital circuit having alternatively high and low levels (abbreviated hereinafter as H and L levels) forming a rectangular waveform, comprises noise pulses, it is preferable to suppress or eliminate the noise pulses by means of a noise suppressing circuit before transferring the input signal to the next stage.

When the noise pulses have a width of short duration, it is known to use a suppressing circuit consisting of a shift register and associated logic elements and utilizing the fact that the width of the noise pulses is short.

However, conventional noise pulse suppressing circuits can only suppress noise pulses having one polarity, either positive or negative.

It is therefore an object of the present invention to provide a circuit capable of suppressing noise pulses having both positive and negative polarities comprised in an input signal.

It is also an object of the present invention to provide a circuit capable of issuing a noise free output pulse signal having a leading edge synchronized with either the leading edge or the trailing edge of a clock signal.

It is still a further object of the present invention to provide a circuit making it possible to determine the maximum pulse width of the noise pulses which should be suppressed.

According to the invention, a noise pulse suppressing circuit is provided for suppressing noise pulses superposed on an input signal having a binary state and outputting an output signal responsive to the binary state of the input signal without noise pulses, the noise pulses suppressing circuit comprising:

- a latch circuit for receiving and latching the input signal in response to a triggering signal, and outputting the output signal

- a counter circuit connected to the latch circuit and receiving a clock signal for generating the triggering signal at the instant when a predetermined number of pulse edges in the clock signal has been counted, and

- a logic circuit connected to the latch circuit and to the counter circuit, for generating a reset signal which is applied to the counter circuit to reset same when the latch circuit output and the input signal have the same logic state, and for making the counter circuit active when the latch circuit output and the input signal have complementary logic states.

Thus, a level change in the input signal will cause a corresponding level change to occur in the output signal on the condition that the counter circuit generates the triggering signal, i.e. the counter circuit is not reset before having counted said predetermined number of clock pulses. When a noise pulse is superposed to the input signal, this noise pulse will not be transferred to the output signal if its width is not sufficient to allow the predetermined number of clock pulses to be counted during the time the counter circuit is made active. The maximum width of the noise pulses to be suppressed is then a function of the frequency of the clock signal and of said predetermined number, and an actual suppression of noise pulses is achieved independently of the polarities of the noise pulses.

Also, the triggering signal being produced by the counter circuit counting edges of the clock pulse signal, an output signal is obtained which has edges synchronized with either leading or trailing edges of pulses in the clock signal.

The invention will be more readily understood from the reading of the following description made with reference to the accompanying drawings wherein:

Figure 1 shows a block diagram illustrating the principle of the present invention;

Figure 2 is a logic diagram of an embodiment of the circuit according to the present invention, where the output signal is triggered by the trailing (negative) edge of a clock signal and two flip-flops are used in a counter circuit;

Figures 3 to 5 show timing charts relative to the embodiment of Figure 2, respectively when the input signal does not comprise noise pulses, when the input signal comprises noise pulses having a negative polarity, and when the input signal comprises noise pulses having a positive polarity;

Figure 6 shows a logic diagram of another embodiment of the circuit according to the invention where the output signal is triggered by the leading (positive) edge of a clock signal;

Figure 7 shows timing charts relative to the embodiment of Figure 6;

Figure 8 is a logic diagram of still another embodiment of the circuit according to the invention utilizing three flip-flops in the counter circuit; and

Figures 9 and 10 show timing charts relative to the embodiment of Figure 8, respectively when the input signal comprises noise pulses having a negative polarity and when the input signal comprises noise pulses having a positive polarity.

In all the Figures, the same references are used to designate the same elements or signals.

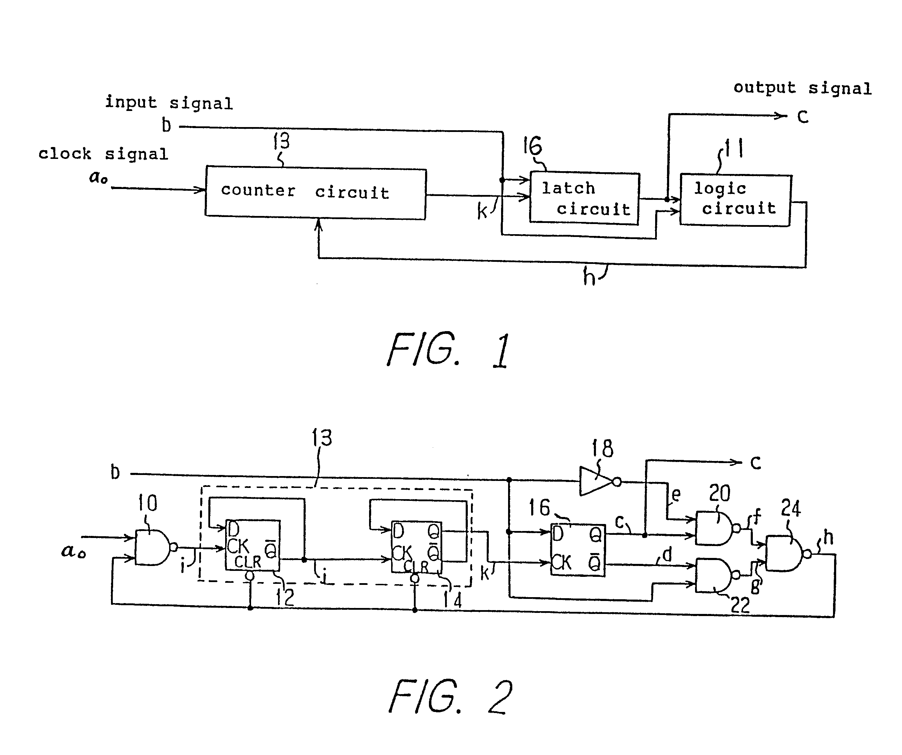

The principle of the invention will be explained with reference to Figure 1. An input signal b is inputted to a latch circuit 16 consisting of a D-type flip-flop providing an output signal c on its data output terminal.

Latch circuit 16 is triggered by a pulse signal k generated by a counter circuit 13 formed of a plurality of D-type flip-flops. Counter circuit 13 receives a clock signal $a_0$ and is controlled by a signal h generated by a logic circuit 11 which comprises, for example, NAND gates and an inverter.

Counter circuit 13 generates the triggering signal k in response to the clock signal $a_0$ and under the control of signal h. The triggering signal k is generated only in response to level changes (edges) in the input signal, in the form of a pulse signal with a predetermined delay time following a level change in the input signal.

With the above described circuit, the generation of a triggering pulse in signal k in response to a noise pulse in the input signal is avoided.

Figure 2 shows a first embodiment of a circuit according to the invention comprising the latch circuit 16 formed by a D-type flip-flop and the counter circuit 13 formed of two D-type flip-flops 12,14.

Logic circuit 11 consists of three NAND gates and an inverter. The inverter 18 receives the input signal b to provide a signal e having an inverted waveform with respect to signal b. A first NAND gate 20 has a first input terminal receiving signal e and a second input terminal connected to the non-inverted output terminal Q of latch circuit 16 to receive signal c. A second NAND gate 22 has a first input terminal receiving the input signal b and a second input terminal connected to latch circuit 16 to receive signal d on the inverted output terminal $\overline{Q}$ thereof. The third NAND gate 24 has input terminals connected to gates 20, 22, respectively, to receive signals f, g on the output terminals thereof and generates control signal h.

The clock signal $a_o$ and signal h are respectively input to the input terminals of a fourth NAND gate 10 which generates a signal i applied as input signal to the counter circuit 13.

Flip-flops 12, 14 forming the counter circuit 13 each have their data input terminal D connected to their inverted output terminal $\overline{Q}$. Flip-flop 12 receives signal i on its clock input terminal CK and outputs a signal j on its inverted output terminal $\overline{Q}$. Signal j is applied to the clock input terminal CK of flip-flop 14 which outputs triggering signal k on its non-inverted output terminal Q. Signal h is also applied to reset terminals CLR of flip-flops 12 and 14.

Triggering signal k is applied to the clock input terminal CK of flip-flop 16 (latch circuit) which receives input signal b on its data input terminal.

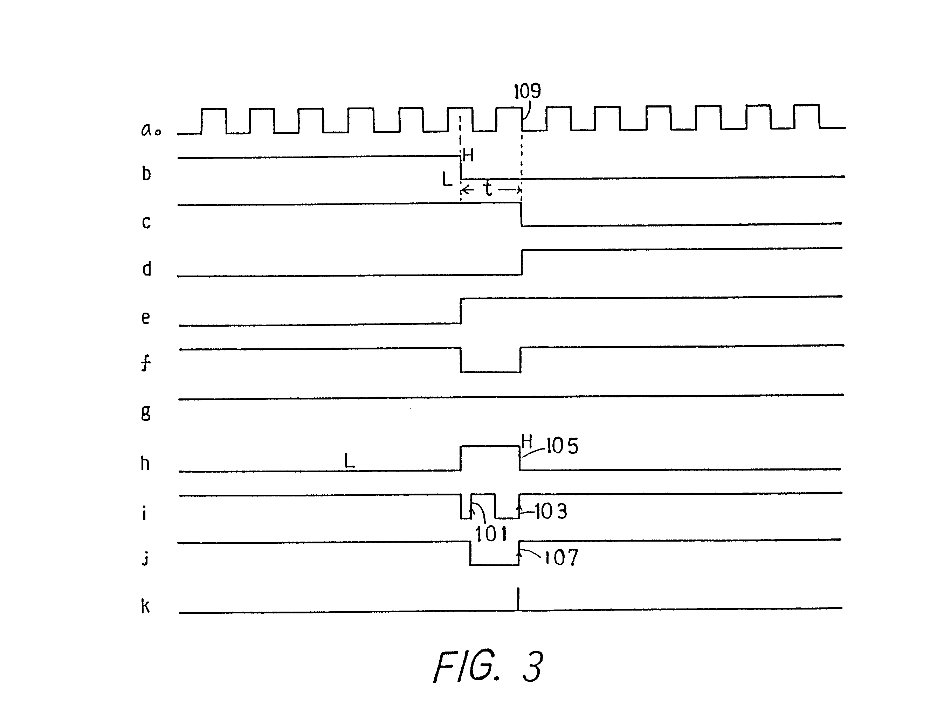

Figs.3 to 5 show waveforms of signals $a_o$ and b to k when the input signal does not include noise pulses, or include narrow noise pulses of negative polarity during a H level portion of the input signals, or include narrow noise pulses of positive polarity during a L level portion of the input signal, respectively.

In a normal operating condition (no noise pulses), the waveform of the input signal b is for example as shown on Fig.3. The clock signal $a_o$ has a rectangular waveform with a duty factor of 50% and shows repeated periodic changes between H and L levels alternatively. The pulse widths at H and L levels in the input signal are assumed to be much longer than the period of clock signal $a_o$.

The output signal c is obtained from the non-inverted data output terminal Q of flip-flop 16. In the example shown in Fig.3, the binary state (level) of output signal c changes in response to a corresponding change of binary state (level) in input signal b, but with a delay time t which begins at the instant when the state (level) of the input signal b changes and ends at the second following trailing edge of the clock signal $a_o$. The flip-flop 16 thus has a function of latching and delaying.

Signals d and e show inverted waveforms with respect to those of signals c and b, respectively. The resulting waveforms of signals f, g and h are shown in Fig.3. Signal h has a L level when signals b and c have the same logic state, and a H level when signals b and c have opposite (complementary) logic states.

Signal i has an inverted waveform with respect to clock signal $a_o$ only when signal h is at H level. In other words, NAND gate 10 has a function of controlling the counter circuit 13 to operate only for the duration of the H level of signal h.

Flip-flop 12 in the counter circuit 13 toggles the inverted data output $\bar{Q}$ triggered by signal i at an instant of a trailing (positive going) edge 101 thereof and the signal j generated by flip-flop 12 inverts its state at the second following trailing (positive going) edge 103 of signal i. The second trailing edge 103 is almost coincident with the trailing edge 105 of signal h which is applied to the reset terminals of flip-flops 12, 14 for resetting the counter circuit 13. As shown in Fig.3, signal j has one pulse during a corresponding period of two pulses of signal i. Flip-flop 12 thus has a function of dividing pulse frequency by two.

Flip-flop 14 toggles the state at its inverted data output terminal $\bar{Q}$ at the trailing (positive going) edge 107 of signal j and resets at the trailing edge 105 of signal h. A signal k having a spike-like pulse is then formed. In Fig.3, trailing edge 107 of signal j seems to be coincident with trailing edge 105 of signal h; however, trailing edge 107 of signal j is synchronous with trailing edge 109 of clock signal $a_o$, whereas trailing edge 105 of signal h is formed through subsequent following shapes. Trailing edge 107 is therefore in advance by an infinitesimal time ahead of trailing edge 105 and a signal k in the form of a pulse of very short duration is formed.

Flip-flop 16 is triggered by the pulse in signal k and toggles and latches input signal b. Therefore, output signal c shows a waveform delayed by a delay time t with respect to signal b, the delay time t beginning at an instant of a level change in input signal b and ending at the second following trailing (negative) edge 109 of clock signal $a_o$.

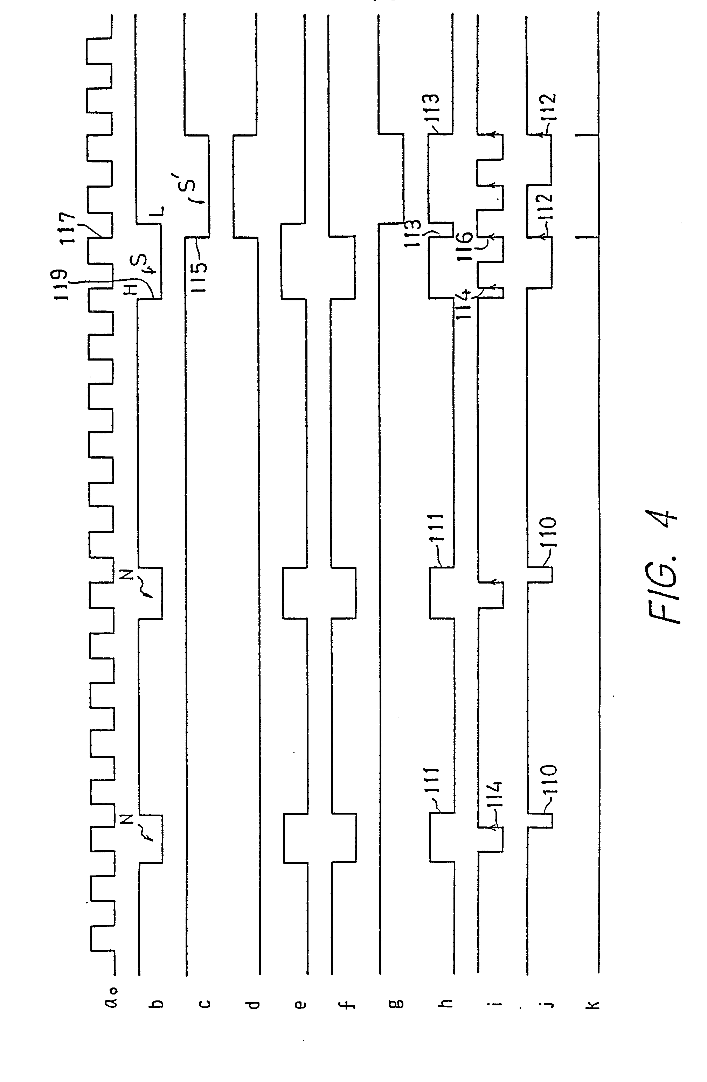

The operation of the noise pulses suppressing circuit will now be described with reference to Fig.4, when noise pulses of negative polarity are superposed on a H level of input signal b. Clock signal $a_o$ has the same rectangular waveform as in the case of Fig.3 and is input to one of the input terminals of NAND gate 10. The data input signal b has H and L levels, each having a duration longer than one period of clock signal $a_o$. In Fig.4, noise pulses N, having a negative polarity and a pulse width shorter than the duration of levels H and L of signal b, are superposed on the H level of input signal.

The result obtained with the noise suppressing circuit will be outlined first. As seen in Fig.4, signal pulse S in input signal b is transferred as signal pulse S' in output signal c. The leading (negative going) edge 115 of S' coincides with the second occurring trailing (negative going) edge 117 of clock signal $a_o$ following the leading (negative going) edge 119 of signal pulse S.

In other words, when the signal pulse S has a duration exceeding the time period between the leading edge of signal pulse S and the second following trailing edge of clock signal $a_0$, then the data pulse is transferred to the output signal. However, pulses of shorter duration such as noise pulses N which encounter only one trailing edge of clock signal $a_0$, are disregarded and not transferred to the output signal.

The fundamental operation is just the same as explained previously except the effects of the noise pulses.

As shown by the waveforms of signals b, c, and h in Fig.4, signal h has a H level when signals b and c have opposite (complementary) logic states, and has a L level when signals b and c have the same logic state.

Signal i has an inverted waveform with respect to the waveform of clock signal pulse $a_0$ only for the duration when signal h is at H level.

Signal j changes from H level to L level at the instant of each trailing (positive) edge 114 of signal i, and inverts its state at the trailing (negative) edge 111 of signal h, or the second following trailing (positive) edge 116 of signal i.

Signal k changes from L level to H level at each trailing (positive) edge 112 of signal j and resets at the trailing edge 113 of signal h.

In signal k shown in Fig.4, two spike pulses are generated only in response to leading and trailing edges of signal S in input signal b, but not in response to the noise pulses N. The reason is as follows.

In response to a noise pulse N, the trailing (positive) edge 110 of signal j coincides with the trailing edge 111 of signal h, which further coincides with that of the noise pulse N; therefore, when flip-flop 14 is going to toggle the inverted data output $\bar{Q}$ triggered by the trailing edge 110 of signal j, flip-flop 14 receives at the same time a reset signal trailing edge 111 of signal h, resulting in no toggle action and no spike pulse in signal k.

However, in response to the leading and trailing edges of signal b, the subsequent trailing edges 112 of signal j are synchronous with a state change of clock signal $a_o$, and are respectively ahead of trailing edges 113 in reset signal h; therefore inverted data output $\bar{Q}$ of flip-flop 14 is toggled and is immediately thereafter reset. Two spike-like pulses are produced in signal k appearing on the non inverted data output terminal Q of flip-flop 14. Thus an output signal c is obtained from the non-inverted data output terminal Q of flip-flop 16 triggered by signal k, which does not include noise pulses and is synchronous with the clock signal $a_o$.

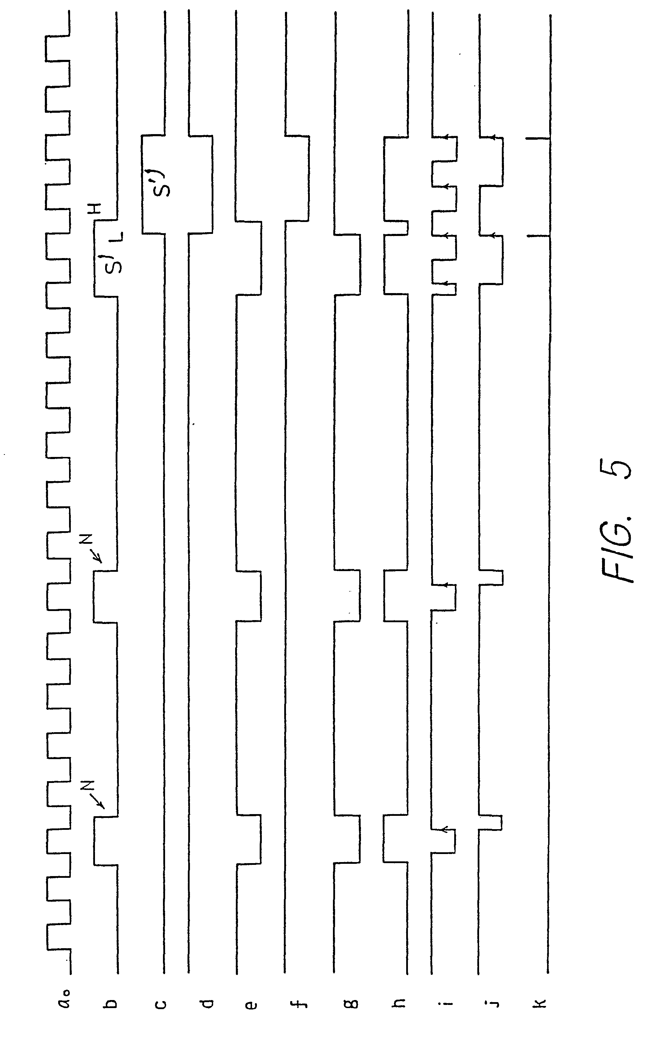

Figure 5 shows timing charts when input signal b comprises noise pulses N of positive polarity during L level portion of the input signal.

In Figure 5, input signal b has an inverted waveform compared to that shown in Figure 4. Comparing Figure 5 with Figure 4, signals c and d in Figure 5 take inverted waveforms compared to those shown in Figure 4, signals f and g are exchanged with each other, and signals h, i, and j remain unchanged. The operation of the noise suppressing circuit is similar to the one described with reference to Figure 4. An output signal c is obtained with a rectangular signal pulse S' corresponding to the signal pulse S in the input signal but with no noise pulses. As a result, the noise suppressing circuit as above disclosed has a function of suppressing noise pulses having both polarities.

In the above described embodiment, the input signal b is transferred to an output signal c being delayed to the second occurring trailing (negative) edge of the clock signal $a_o$ from an instant of state change (H/L) of the input signal. However, it can be possible to modify the circuit to utilize the leading (positive) edge of the clock signal; also, the number of clock pulses included in the delay time between signals b and c can be changed by modifying the counter circuit.

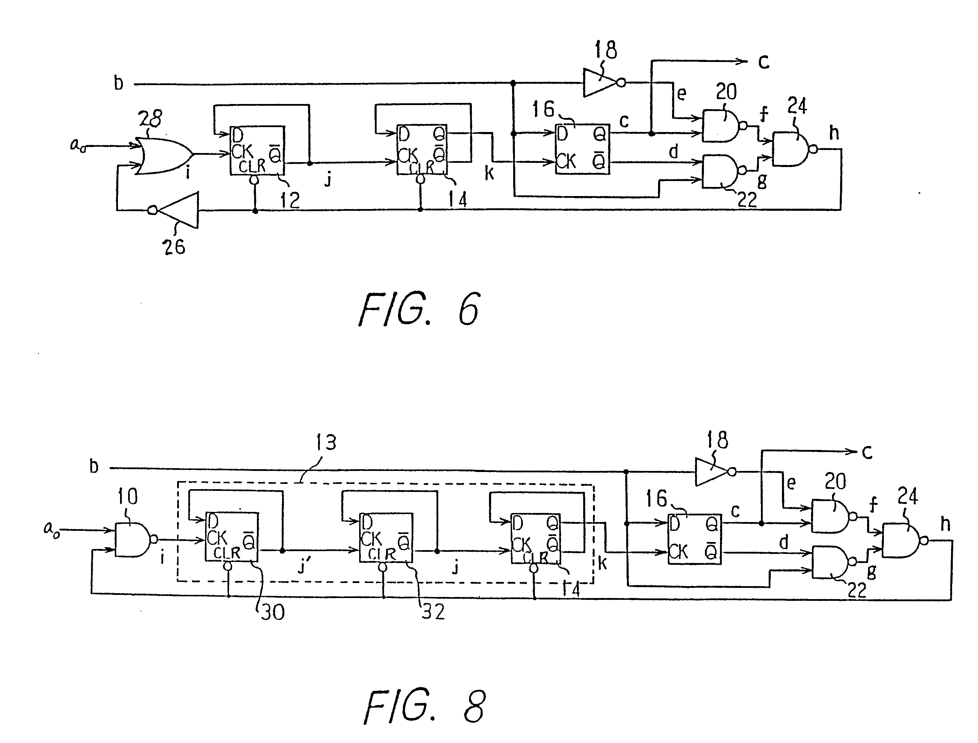

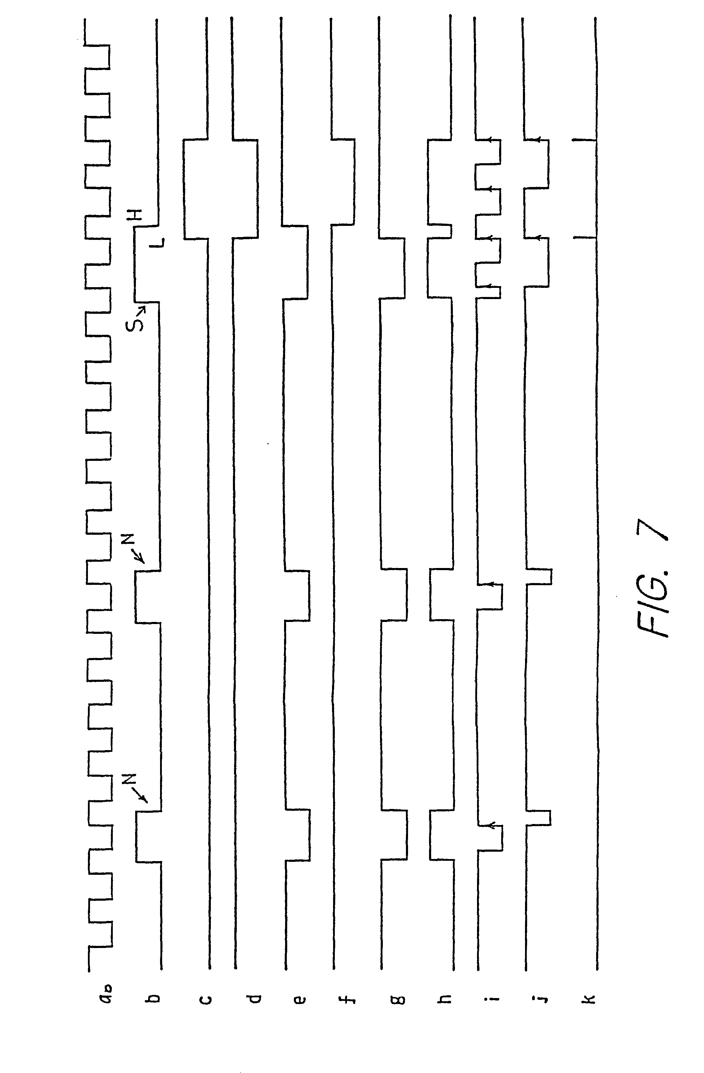

Figure 6 shows a circuit using the leading (positive) edge of clock signal $a_o$, and Figure 7 shows a timing chart relative to the circuit of Figure 6 when noise pulses of positive polarity are superposed to the input signal.

The circuit of Figure 6 is similar to the one of Figure 2, except that an inverter 26 and an OR gate 28 are provided instead of NAND gate 10. The inverter receives signal h and applies the inverted signal h to one input terminal of the OR gate 28. The other input terminal of OR gate 28 receives clock signal $a_o$ and the signal appearing on the output terminal of OR gate 28 is signal i applied to the clock input terminal CK of flip-flop 12.

From Figure 7, it is apparent that the waveforms of signals b through k are exactly the same as those shown in Figure 5. Only clock signal $a_o$ shows an inverted waveform with respect to the one shown in Figure 5. Accordingly, the leading edge of output signal c is triggered by the leading (positive) edge of clock signal $a_o$.

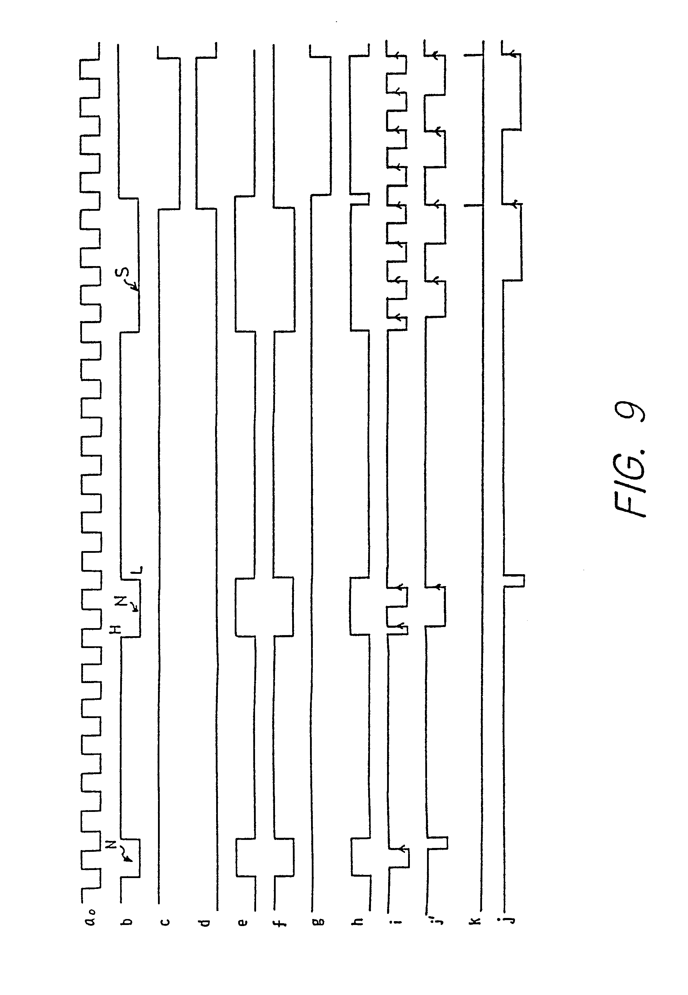

Figure 8 shows a noise pulse suppressing circuit using a counter circuit which consists of three D-type flip-flops 30, 32, and 14, the remaining parts of the circuit being the same as in the embodiment shown in Figure 2. Each one of the flip-flops 30, 32 has its inverted data output terminal $\bar{Q}$ connected to its data input terminal D and has a reset terminal CLR receiving signal h. Signal i from NAND gate 10 is applied to the clock input terminal CK of flip-flop 30. Signal j' on the inverted data output terminal $\bar{Q}$ of flip-flop 30 is applied to the clock input terminal CK of flip-flop 32 which outputs signal j on its inverted output terminal $\bar{Q}$.

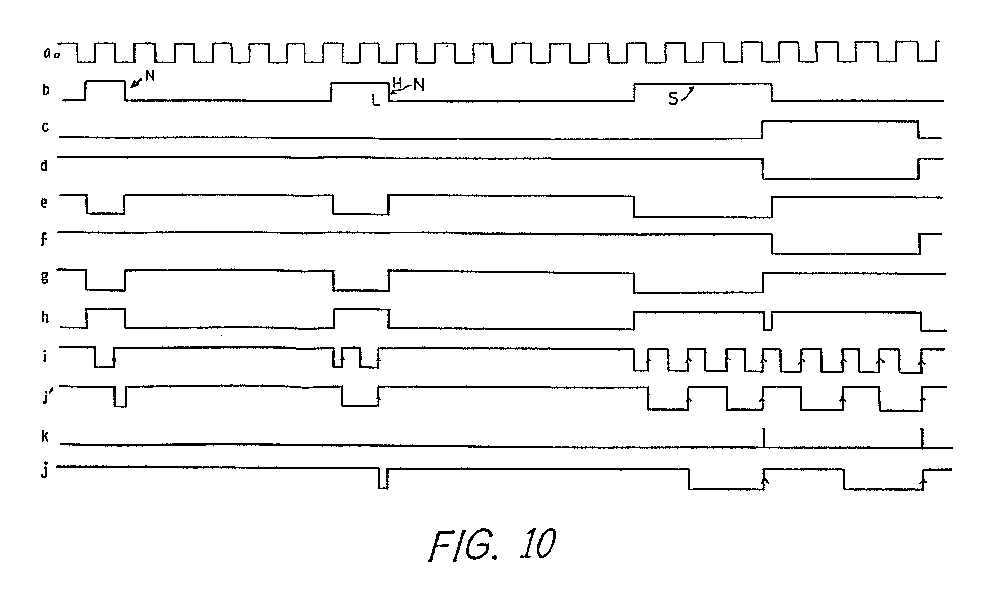

A timing chart when the input signal b comprises noise pulses having a negative polarity during H level portion of the input signal, is shown in Figure 9, and a timing chart when the input signal b comprises noise pulses having a positive polarity during L level portion of the input signal, is shown in Figure 10.

In the example illustrated, the clock signal $a_o$ shows 4 trailing (negative) edges during the duration of signal pulse S in the input signal b, and noise pulses will be suppressed provided that their duration does not exceed a time during which two trailing edges of the clock signal appear.

With the circuit of Figure 8, the output signal c is delayed with respect to the input signal up to the fourth trailing edge of the clock signal $a_o$ following a level change of the input signal. A synchronization of the output signal edges on leading edges of the clock signal would be possible by modifying the circuit as shown on Figure 5, which would result in delaying the output signal with respect to the input signal up to the fourth leading edge of the clock signal following a level change in the input signal.

In Figures 9 and 10, j' is added which displays the waveform on the connection line between flip-flops 30 and 32. As seen from waveforms of i, j', and j, the number of pulses is successively decreased by a half.

From the preceding description it is apparent that noise pulses are suppressed on the condition that their duration (width) is not sufficient to allow more than one (Figures 2 and 6) or more than two trailing edges of the clock signal to appear. Similarly, noise pulses of still longer duration can be suppressed by increasing the number of flip-flops in the counter circuit, the frequency of the clock signal remaining unchanged. The output signal will be delayed with respect to the input signal by a time period which is a function of the number of flip-flops in the counter circuit. When the counter circuit is formed of a number N of D-type flip-flops connected in cascade, the output signal is delayed with respect to the input signal up to the $2(N-1)$th trailing or leading edge of the clock signal following a level change of the input signal.

Obviously, the maximum width of the noise pulses to be suppressed will not only be determined by the number of flip-flops in the counter circuit, but also by the frequency of the clock signal.

In conclusion, the noise pulses suppressing circuit according to the present invention shows the following features:

(a)   suppression of noise pulses having both positive and negative polarities,

(b)   transfer of an input signal to  an   output  signal while synchronizing with a clock signal,

(c)   possibility of utilizing either the leading edge  or the  trailing edge of the clock signal for synchronization  of  the output signal, and

(d)   possibility of determining the  maximum  width  of noise  pulse  by  selecting the frequency of clock  signal  or  the number of flip-flops used in the counter circuit.

## CLAIMS

1.        A noise pulse suppressing circuit for suppressing noise pulses superposed on an input signal having a binary state, and outputting an output signal responsive to the binary state of the input signal without said noise pulses, said noise pulse suppressing circuit being characterized in that it comprises:

a latch circuit (16) for receiving and latching the input signal (b) in response to a triggering signal (k), and outputting the output signal (c),

a counter circuit (13) connected to the latch circuit (16) and receiving a clock signal ($a_0$) for generating the triggering signal at the instant when a predetermined number of pulse edges in the clock signal has been counted, and

a logic circuit (11) connected to the latch circuit (16) and to the counter circuit (13) for generating a reset signal (h), which is applied to the counter circuit to reset same when the latch circuit output and the input signal have the same logic state, and for making the counter circuit active when the latch circuit output and the input signal have complementary logic states.

2.        A noise pulse suppressing circuit according to claim 1, wherein said latch circuit (16) consists of a D-type flip-flop.

3.        A noise pulse suppressing circuit according to any one of claims 1 and 2 wherein said counter circuit comprises a plurality of D-type flip-flops (12, 14; 30, 32, 14) having a data terminal, a clock terminal, a data output terminal, an inverted output terminal and a reset terminal, each with its data input terminal connected to its own inverted output terminal and each inverted output terminal being connected to the clock terminal of the flip-flop in the following stage, except the last stage where the data output terminal is connected to a clock terminal of the latch circuit (16).

4.        A noise pulse suppressing circuit according to claim 3, wherein said logic circuit (11) comprises:

a first NAND gate (20) for receiving the output signal (c) from the latch circuit (16) and the input signal in inverted state,

a second NAND gate (22) for receiving said input signal (b) and the output signal from the latch circuit in inverted state,

a third NAND gate (24) for receiving outputs from the first and second NAND gates and outputting said reset signal (h) which is applied to each reset terminal of the flip-flops of the counter circuit (13), and

a fourth NAND gate (10) for receiving said clock signal ($a_0$) and said reset signal (h) from the third NAND gate, the output signal from the fourth NAND gate being inputted to the clock terminal of the first stage flip-flop (12;30) of the counter circuit (13).

5. A noise pulse suppressing circuit according to claim 3, wherein said logic circuit (11) comprises:

a first NAND gate (20) for receiving the output signal (c) from the latch circuit (16) and the input signal in inverted state,

a second NAND gate (22) for receiving said input signal (b) and the output signal from the latch circuit in inverted state,

a third NAND gate (24) for receiving outputs from the first and second NAND gates and outputting said reset signal (h) which is applied to each reset terminal of the flip-flops of the counter circuit (13),

an inverter (26) for inverting the output signal from said third NAND gate (24), and

an OR gate (28) for receiving said clock signal ($a_0$) and the output signal from the inverter (26), the output signal from the OR gate (28) being inputted to the clock terminal of the first stage flip-flop (12) of said counter circuit (13).

6. A noise pulse suppressing circuit according to any one of claims 3 to 5, wherein said counter circuit (13) comprises two D-type flip-flops (12, 14), and the output signal is delayed with respect to input signal up to the second trailing edge of the clock signal following a level change of the input signal.

7. A noise pulse suppressing circuit according to any one of claims 3 to 5, wherein said counter circuit (13) comprises two D-type flip-flops (12, 14), and the output signal is delayed with respect to the input signal up to the second leading edge of the clock signal following a level change of the input signal.

8. A noise pulse suppressing circuit according to any one of claims 3 to 5, wherein said counter circuit (13) comprises three D-type flip-flops (30, 32, 14), and the output signal is delayed with respect to the input signal up to the fourth trailing edge of the clock signal following a level change of the input signal.

9. A noise pulse suppressing circuit according to any one of claims 3 to 5, wherein said counter circuit (13) comprises three D-type flip-flops, and the output signal is delayed with respect to the input signal up to the fourth leading edge of the clock signal following a level change of the input signal.

10. A noise pulse suppressing circuit according to any one of claims 3 to 5, wherein said counter circuit comprises N units of D-type flip-flops connected in cascade, and the output signal is delayed with respect to the input signal up to the $2(N-1)$-th edge of the clock signal following a level change in the input signal.

input signal

output signal

clock signal

counter circuit

latch circuit

logic circuit

FIG. 1

FIG. 2

FIG. 3

2/8

0243235

FIG. 4

0243235

FIG. 5

4/8

0243235

FIG. 6

FIG. 8

FIG. 7

6/8

0243235

FIG. 9

7/8

024235

FIG. 10

0243235